# EUROPEAN PATENT APPLICATION

(11) **EP 3 185 423 A1**
(43) Date of publication of application: **28.06.2017**
(21) Application number: 16196904.3
(22) Date of filing: 02.11.2016
(51) Int. Cl.: H03K 17/969

(54) **MODULAR PHOTOELECTRIC-SWITCH KEYBOARD KEY**

(30) Priority: 18.12.2015 CN 201510964805
(71) Applicant: Dongguan Gaote Electronics Co., Ltd., Dongguan City, Guangdong 523000 (CN)
(72) Inventor: FENG, Jianqing, Dongguan City, Guangdong 523000 (CN)
(74) Representative: Casalonga

(57) **Abstract**

The present invention relates to a modular photoelectric-switch keyboard key, including modular photoelectric switch, base, keymodule and elastic element, the said modular photoelectric switch is mounted in the said base, the said keymodule is slideably placed in the sliding cavity of the said base and the said elastic element is placed between the said base and the said keymodule; the said modular photoelectric switch comprises transmitting tube, receiving tube and distance piece, the said transmitting tube and the said receiving tube are placed oppositely and are electrically connected with the circuit board; the said distance piece is connected with the said keymodule and located between the said transmitting tube and the said receiving tube; Pressing on the said keymodule causes the said distance piece to slide to or away from the position between the said transmitting tube and the said receiving tube so as to block or conduct the signal transmission between the said transmitting tube and the said receiving tube. The present invention has such advantages as simple structure, quick switch response, long service life as well as water- and dust resistance, etc..

## Description

### Technical field

This invention relates to a keyboard, in particular, a modular photoelectric-switch keyboard key.

### Background art

Mechanical keyboard is a kind of commonly seen keyboard. Each key of such kind of keyboard is controlled by an independent switch for closing. An elastic conductive part is propelled by a key to establish an electrical connection with or disconnection from another conductive part, thus, completing the keystroke operation; Since mechanical keyboards give unique tactile feedback and sound during keystroke, it is increasingly welcomed by computer users.

However, there are also many shortcomings to traditional mechanical keyboards. For example, complicated mechanical structure, cumbersome installation, slow switch response speed, susceptibility for short-circuiting when coming in contact with water, susceptibility for circuit breaking when coming in contact with dust, easy wearing of contact points or easy occurrence of metal fatigue after long-time use, as well as short service life.

### Description of the invention

An object of the present invention is to provide a water- and dust-proof modular photoelectric-switch keyboard key with simple structure, quick switch response speed and long service life.

To achieve the aforementioned object, the modular photoelectric-switch keyboard key according to the present invention comprises modular photoelectric switch, base, keymodule and elastic element, the said modular photoelectric switch is mounted in the said base, the said keymodule is slideably placed in the sliding cavity of the said base and the said elastic element is placed between the said base and the said keymodule; the said modular photoelectric switch comprises transmitting tube, receiving tube and distance piece, the said transmitting tube and the said receiving tube are placed oppositely and are electrically connected with the circuit board; the said distance piece is connected with the said keymodule and located between the said transmitting tube and the said receiving tube; Pressing on the said keymodule causes the said distance piece to slide to or away from the position between the said transmitting tube and the said receiving tube so as to block or conduct the signal transmission between the said transmitting tube and the said receiving tube.

In contrast with prior art, the said transmitting tubes and the said receiving tubes according to the present invention are respectively placed oppositely so that the said distance piece is placed between the said transmitting tube and receiving tube, and the said distance piece is connected with the said keymodule, when the said keymodule propels the said distance piece to slide to a position between the said transmitting tube and the said receiving tube, this can block the signal transmission between the said transmitting tube and the said receiving tube; also provided is the said elastic element, rebound force of the said elastic element can cause the said distance piece to leave the position between the said transmitting tube and the said receiving tube, thus, conducting the signal transmission between the said transmitting tube and the said receiving tube. Therefore, sliding of the said distance piece causes the signal to be conducted or blocked to fulfill the turn on/off function, thus, completing a keystroke operation of the keyboard; The use of photoelectric element as the switching structure of the keyboard key not only provides for simple structure, quick installation, fast switch response speed, but also enables that signals are transmitted by light without the need for any conductive metal part, having a water- and dust-proofing effect, and furthermore, the said distance piece does not have a direct contact with the said transmitting tube and receiving tube, without causing any wear or metal fatigue, thus, extremely extending its service life.

Preferably, the said modular photoelectric switch also comprises a housing, the said housing fixedly mounted on the said base, the said housing has two pairs of tube holders, the said two pairs of tube holders have an on-off slot between them, the said transmitting tube and the said receiving tube are respectively mounted in the said two pairs of transmitting holders, and the transmitting port of the said transmitting tube and the receiving port of the said receiving tube face the said on-off slot and directly face each other. By providing two pairs of tube holders on the said housing, it is possible to limit the position of the said transmitting tube and receiving tube, and have them directly facing each other via the on-off slot between them, making signal transmission possible.

Specifically, the said two pairs of tube holders has a through slot on the side near the said on-off slot, and the said transmitting port and the said receiving port directly face the said through slot. Since the said transmitting tube and the said receiving tube are mounted in the said pairs of holders, the provision of the said through slot enables the said transmitting port and the said receiving port to have external connection, thus, making signal transmission possible.

Specifically, an engagement portion is provided on the side of the said transmitting tube and the said receiving tube, and a mating portion for connecting with the said engagement portion is provided on the side wall for the said two tube holders to correspond with the said engagement portion. By providing the said engagement portion and the said mating portion, it is possible to quickly position the said transmitting tube, allowing for easy erection.

Specifically, a lock piece is provided at the bottom of the housing, and the said lock piece is locked with the circuit board. The said lock piece enables the said housing to be quickly connected with the said circuit board, allowing for easy erection and improving the subassembly speed.

Preferably, the said modular photoelectric-switch keyboard key also includes an elastic strip, the said elastic strip is fixed on the said base, the said elastic strip has elastic tongue piece, the said keymodule is provided with a retainer portion, and the said elastic tongue piece provides an elastic force perpendicular to the sliding direction of the said keymodule and retains against the said retainer portion. By providing the said elastic strip and providing a retainer portion on the said keymodule, it is possible for the said elastic strip to produce an elastic force against the said retainer portion, giving a tactile feel to the modular photoelectric-switch keyboard key of the present invention when it is depressed, which is a key feel unique to mechanical keyboards.

Specifically, the said keymodule comprises plunger and slider that is slideably connected outside the said plunger; the said plunger is provided with a suspension portion, and when the key is not pressed, the said slider is suspended on the said suspension portion, and the said retaining portion presses against the said elastic tongue piece. By dividing the said keymodule into two parts, namely, plunger and slider, it is possible to cause the said plunger and the said slider to produce a sound of collision when depressing the modular photoelectric-switch keyboard key of the present invention, simulating the sound of mechanical keyboard and reinforcing the sound when typing on the keyboard.

Preferably, locating pole is provided on the underside of the said base, and the said locating pole is inserted into the locating hole of the circuit board. The said locating pole may, during erection, enable the said base to locate quickly, thus, improving the erection efficiency.

Preferably, the said base has an elastic hook provided on one side of the base, a fixing plate is provided above the said circuit board, the said base is mounted on the opening of the said fixing plate and the said elastic hook is clamped on the rim of the said opening. The said elastic hook enables the said base to be quickly located, dispensing with tin soldering and other procedures, thus, improving the erection efficiency.

Preferably, the said base comprises a top cover and housing, either the said top cover or the said housing is provided with a engagement hook, the other one of the said top cover or the said housing has an engagement portion, and when the said top cover is covered on the said housing, the said engagement hook is engaged with the said engagement portion. By making the said base into two parts, namely, the top cover and the housing, and by mating the said engagement hook with the engagement portion, subassembly is made easier.

### Brief description of the drawings

Fig. 1 is a schematic structural view illustrating the modular photoelectric-switch keyboard key of embodiment 1 of the present invention.
Fig. 2 is a top view showing the modular photoelectric-switch keyboard key of embodiment 1 of the present invention.
Fig. 3 is a disassembly schematic view showing the modular photoelectric-switch keyboard key of embodiment 1 of the present invention.
Fig. 4 is a sectional view of Fig. 2 through A-A.
Fig. 5 is a sectional view of Fig. 2 through B-B.
Fig. 6 is a structural view showing the slider and elastic strip in the modular photoelectric-switch keyboard key of embodiment 1 of the present invention.
Fig. 7 is a schematic structural view showing the modular photoelectric switch according to the present invention.
Fig. 8 is a disassembly view showing the modular photoelectric switch according to the present invention.
Fig. 9 is a schematic structural view showing the housing of the modular photoelectric switch according to the present invention.
Fig. 10 is a schematic view showing bottom structure of the housing of the modular photoelectric switch according to the present invention.
Fig. 11 is a schematic structural view showing the receiving tube of the modular photoelectric switch according to the present invention.
Fig. 12 is a schematic structural view showing the keymodule of the modular photoelectric-switch keyboard key of embodiment 2 of the present invention.

### Detailed description of the preferred embodiments

A detailed description of the technical aspects, structural characteristics and fulfilled effects of the present invention is given below in conjunction with the implementation method and with reference to the appended drawings.

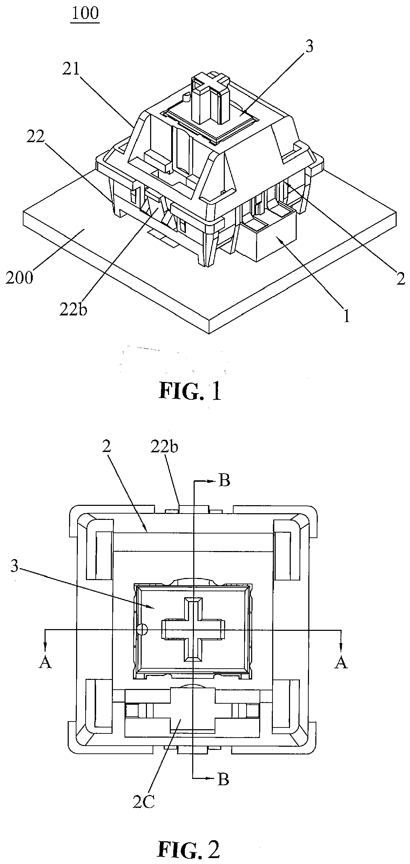

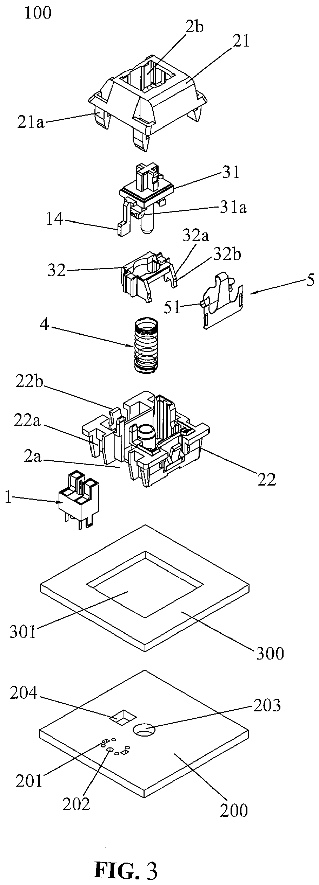

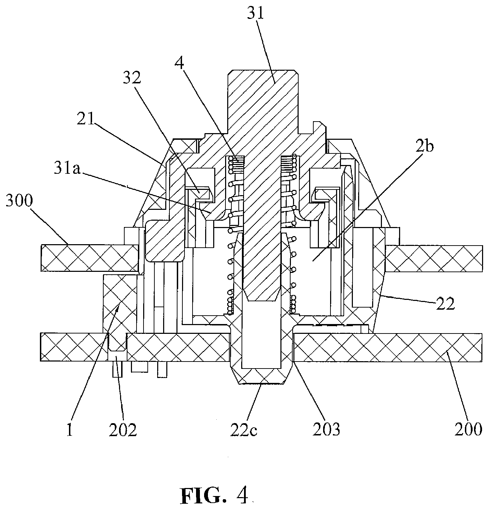

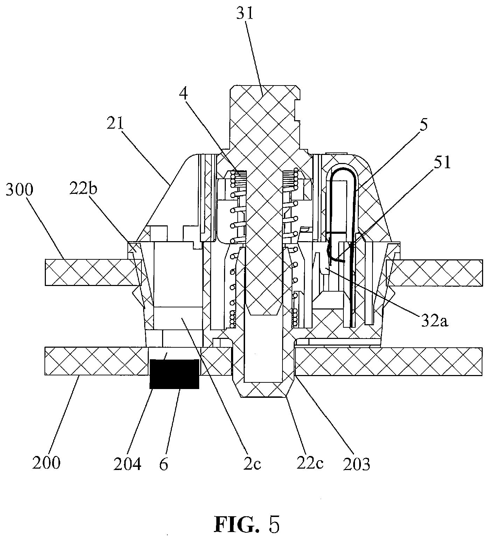

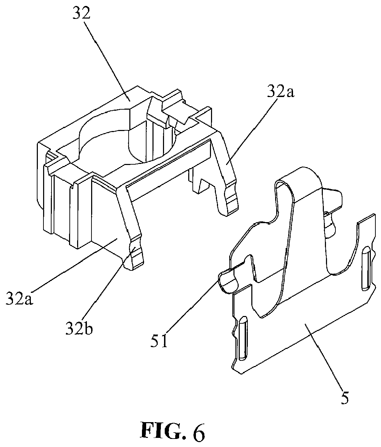

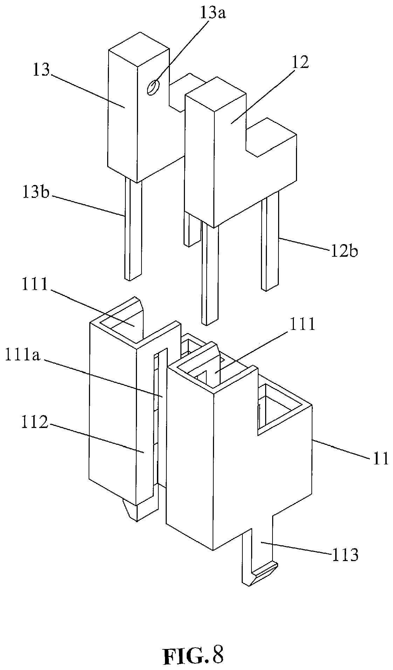

As shown in Figs. 1 thru 11, the modular photoelectric-switch keyboard key 100 of Embodiment 1 of the present invention is mounted on circuit board 200 and is held on fixing plate 300 above the said circuit board 200, which comprises modular photoelectric switch 1, base 2, keymodule 3 and elastic element 4, on the said base 2 are provided mount 2a and upright sliding cavity 2b with a top opening, the said modular photoelectric switch 1 is mounted on the said mount 2a, the said keymodule 3 is slideably placed inside the said sliding cavity 2b with its upper end extended out of the said base 2, the said elastic element 4 is placed between the said base 2 and the said keymodule 3.

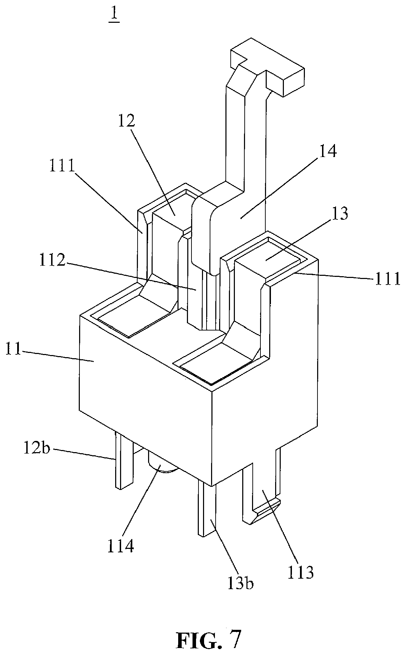

Now referring to Figs. 7 thru 11, the said modular photoelectric switch 1 comprises housing 11, transmitting tube 12, receiving tube 13 and distance piece 14, the said transmitting tube 12 has a outline structure identical to receiving tube 13, which is a L-shaped structure, the said housing 11 has two pairs of tube holders 111 corresponding with transmitting tube 12 and receiving tube 13, the said two pairs of tube holders 111 are placed in row with a space in between, an on-off slot 111 is provided between the said two pairs of tube holders 111, the said transmitting tube 12 and the said receiving tube 13 are respectively mounted in the said two pairs of tube holders 111 respectively, the transmitting port of the said transmitting tube 12 (not shown in the drawing) and the receiving port 13a of the said receiving tube 13 face the said on-off slot 112 and directly face each other, the said distance piece 14 is slideably placed in the said on-off slot 112, the said distance piece 14 is fixed connected with the said keymodule 3, and a press on the said keymodule 3 makes the said keymodule 3 propel the said distance piece 14 to slide between the said transmitting tube 12 and the said receiving tube 13, when the said distance piece 14 is located between the said transmitting tube 12 and the said receiving tube 13, signal transmission between the said transmitting port and the said receiving port 13a is blocked, and when the said distance piece 14 leaves the place between the said transmitting tube 12 and the said receiving tube 13, signal transmission between the said transmitting port and the said receiving port 13a is conducted.

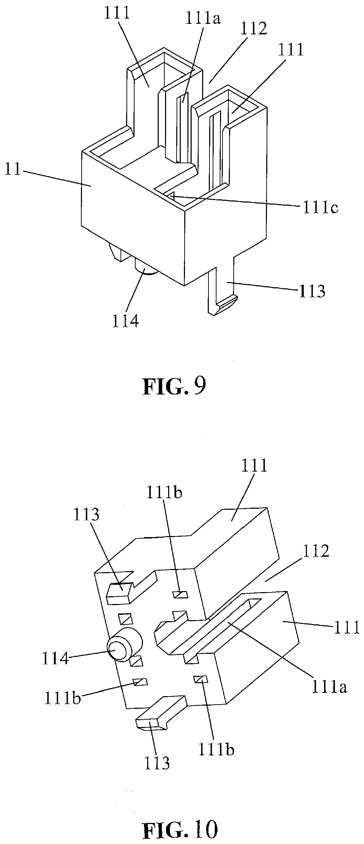

Referring to Figs. 9 & 10, the said two pairs of tube holders 111 has a through slot 111a on the side near the said on-off slot 112, and the said transmitting port and the said receiving port 13a directly face the said through slot 111a. Since the said transmitting tube 12 and the said receiving tube 13 are mounted in the said pairs of holders 111, the provision of the said through slot 111a enables the said transmitting port and the said receiving port 13a to have external connection, thus, making signal transmission possible. The said two pairs of tube holders 111 both have two downwardly through hole 111b at the bottom, and the two pins 12b and 13b at the bottom of the said transmitting tube 12 and the said receiving tube 13 are connected with the circuit board through their respective corresponding through hole 111b. The said through hole 111b not only enables the pins 12b and 13b of the said transmitting tube 12 and the said receiving tube 13 to directly extend out and connect with the circuit board, but also can conceal the pins 12b and 13b inside the said housing 11, keeping them away from the influence of dust and liquid.

Again referring to Figs. 9 & 10, a lock piece 113 is provided at the bottom of the said housing 11, and the said lock piece 113 is locked with the lock hole 201 of the said circuit board 200. The said lock piece 113 enables the said housing 11 to be quickly connected with the said circuit board 200, allowing for easy erection and improving the subassembly speed. A locating pole 114 is provided on the underside of the said housing 11, and the said locating pole 114 is inserted into the locating hole 202 of the said circuit board 200. The said locating pole 114 is helpful for a quick positioning during subassembly of the said housing 11 and the said circuit board 200, thus, improving the subassembly speed.

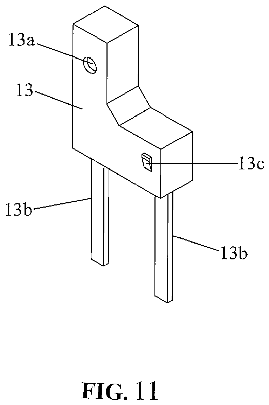

Now referring to Figs. 9 and 11, an engagement portion 13c is provided on the side of the said transmitting tube 12 and the said receiving tube 13, and a mating portion 111c for connecting with the said engagement portion 13c is provided on the side wall for the said two tube holders 111 to correspond with the said engagement portion 13c. By providing the said engagement portion 13c and the said mating portion 111c, it is possible to quickly position the said transmitting tube 12, allowing for easy erection.

Referring to Figs. 2 thru 6, the said keymodule 3 comprises plunger 31 and slider 32 that is vertically and slideably connected outside the said plunger 31; the said distance piece 14 is fixedly connected on one side of the said plunger 31; the said plunger 31 is provided with a suspension portion 31a, and when the key is not pressed, the said slider 32 is suspended on the said suspension portion 31a. The said modular photoelectric-switch keyboard key 100 also includes an elastic strip 5, the said elastic strip 5 is fixed on the said base 2, the said elastic strip 5 has elastic tongue piece 51, the said slider 32 is provided with a retainer portion 32a on one side, the said retainer portion 32a has an engagement position 32b, and when the said retainer portion 32a presses against the said elastic tongue piece 51, the said elastic tongue piece 51 is elastically engaged in the said engagement position 32b, and the said elastic tongue piece 51 provides an elastic force perpendicular to the sliding direction of the said slider 32 and presses against the said retainer portion 32a, so that the said slider 32 can still be suspended inside the said sliding cavity 2b when the said keymodule 31 slides down. By dividing the said keymodule 3 into two parts, namely, plunger 31 and slider 32, it is possible to cause the said plunger 31 and the said slider 32 to produce a sound of collision when depressing the modular photoelectric-switch keyboard key 100 of the present invention, simulating the sound of mechanical keyboard and reinforcing the sound when typing on the keyboard. And by providing the said elastic strip 5 and providing a retainer portion 32a on the said slider 32, it is possible for the said elastic strip 5 to produce an elastic force against the said retainer portion 32a, giving a tactile feel to the modular photoelectric-switch keyboard key 100 of the present invention when it is depressed, which is a key feel unique to mechanical keyboards.

As shown in Fig. 1, Fig. 3 and Fig. 4, the said base 2 comprises a top cover 21 and housing 22, the said top cover 21 is provided with an engagement hook 21a, the said housing 22 is provided with an engagement portion 22a, and when the said top cover 21 is covered on the said housing 22, the said engagement hook 21a is engaged with the said engagement portion 22a. By making By making the said base 2 into two parts, namely, the top cover 21 and the housing 22, and by mating the said engagement hook 21a with the engagement portion 22a, subassembly is made easier. The said housing 22 has elastic hooks 22b provided on both opposite sides of the base, the said housing 22 is mounted on the opening 301 of the said fixing plate 300 and the said elastic hook 22b is clamped on the rim of the said opening 301. The said elastic hook 22b enables the said base 2 to be quickly fixed, dispensing with tin soldering and other procedures, thus, improving the erection efficiency. A locating pole 22c is provided on the underside of the said housing 22, and the said locating pole 22c is inserted into the locating hole 203 of the said circuit board 200. The said locating pole 22c is helpful for a quick positioning of the said base 2 during erection, thus, improving the erection speed. The said locating pole 22c extends towards the inside of the said housing 22, and a guide hole is provided in the middle, so that when the said plunger 31 slides inside the said sliding cavity 2b, the sleeve of the said plunger 31 is connected inside the said guide hole for the purpose of guiding. LED lamp mount 204 is also provided on the said circuit board 200, and a LED lamp through hole 2c is also provided on the said housing 22, surface mount type LED lamp 6 is mounted by taking advantage of LED mount 204, the light produce a backlit effect for the modular photoelectric-switch keyboard key through the LED lamp through hole 2c.

To sum up the above and with reference to the appended drawings, in the initial state of the modular photoelectric-switch keyboard key 100 according to the present invention, the said slider 32 is suspended on the suspension portion 31a of the said plunger 31, the retainer portion 32a of the said slider 32 presses again the elastic tongue piece 51 of the said elastic strip 5; during operation, a press on the said plunger 31 makes the said plunger 31 slide downwards along the said sliding cavity 2b, at which point, since the elastic force of the said elastic tongue piece 51 presses again the said retainer portion 32a, the said slider 32 is at standstill; when the said plunger 31 slides to a certain stroke, the said plunger 31 collide with the said slider 31, making the said slider 32 slide downwards along the said plunger 31, and in the meanwhile, the said plunger 31 propels the said distance piece 14 move downwards, the said distance piece 14 moves in the said on-off slot 112 downwards to a place between the said transmitting port and the said receiving port 13a, whereby the signal transmission between the said transmitting tube 12 and the said receiving tube 13 is cut off, resulting in a signal change, and completing a keystroke operation. At last, under the action of the rebound force of the said elastic element 4, the said plunger 31 moves upwards and propels the said slider 32 to move upwards, thus, returning to the initial state.

In contrast with prior art, the said transmitting tubes 12 and the said receiving tubes 13 according to the present invention are respectively placed oppositely so that the said distance piece 14 is placed between the said transmitting tube 12 and receiving tube 13, and the said distance piece 14 is connected with the said keymodule 3, when the said keymodule 3 propels the said distance piece 14 to slide to a position between the said transmitting tube 12 and the said receiving tube 13, this can block the signal transmission between the said transmitting tube 12 and the said receiving tube 13; also provided is the said elastic element 4, rebound force of the said elastic element 4 can cause the said distance piece 14 to leave the position between the said transmitting tube 12 and the said receiving tube 13, thus, conducting the signal transmission between the said transmitting tube 12 and the said receiving tube 13. Therefore, sliding of the said distance piece 14 causes the signal to be conducted or blocked to fulfill the turn on/off function, thus, completing a keystroke operation of the keyboard; The use of photoelectric element as the switching structure of the keyboard key not only provides for simple structure, quick installation, fast switch response speed, but also enables that signals are transmitted by light without the need for any conductive metal part, having a water- and dust-proofing effect, and furthermore, the said distance piece 14 does not have a direct contact with the said transmitting tube 12 and receiving tube 13, without causing any wear or metal fatigue, thus, extremely extending its service life; Furthermore, the present invention produces striking sound and gives a tactile feel when the key is depressed, which is a key feel unique to mechanical keyboards.

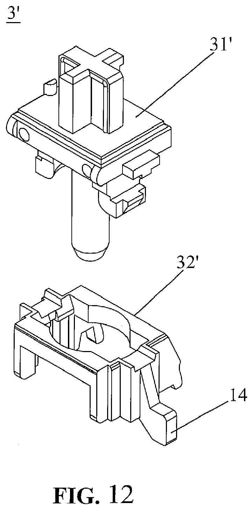

The modular photoelectric-switch keyboard key of Embodiment 2 of the present invention has a structure identical to that of Embodiment 1, and the difference lies in keymodule 3' ; as shown in Fig. 12, the keymodule 3' of this embodiment is also divided into two parts, namely, plunger 31' and slider 32' , however, the said distance piece 14 is provided on slider 32' , the function of which is totally identical to

Embodiment 1. Thus, no detailed description is given herein again.

Additionally, the modular photoelectric-switch keyboard key according to the present invention can also have the said keymodule made into other structures, so that it can give a clicky, tactile feel, non-clicky tactile feel as well as linear feel, eg., the keymodule can be made into a monolithic structure while other structures remaining the same, whereby the keyboard will give a non-clicky, tactile feel.

Internal structure and working principle of the transmitting tube 12 and the receiving tube 13 involved in the modular photoelectric-switch keyboard key according to the present invention are all well known by technical persons skilled in the art, and thus no detailed description is given again herein.

Disclosed above are just preferred embodiments of the present invention, and by no means should these limit the scope of the present invention, thus, it should be understood that any equivalent variation made within the scope of the patent application of the present invention shall be still covered thereby.

## Claims

1. A modular photoelectric-switch keyboard key, wherein it includes modular photoelectric switch, base, keymodule and elastic element, the said modular photoelectric switch is mounted in the said base, the said keymodule is slideably placed in the sliding cavity of the said base and the said elastic element is placed between the said base and the said keymodule; the said modular photoelectric switch comprises transmitting tube, receiving tube and distance piece, the said transmitting tube and the said receiving tube are placed oppositely and are electrically connected with the circuit board; the said distance piece is connected with the said keymodule and located between the said transmitting tube and the said receiving tube; Pressing on the said keymodule causes the said distance piece to slide to or away from the position between the said transmitting tube and the said receiving tube so as to block or conduct the signal transmission between the said transmitting tube and the said receiving tube. The present invention has such advantages as simple structure, quick switch response, long service life as well as water- and dust resistance, etc..

2. A modular photoelectric-switch keyboard key according to Claim 1, wherein the said modular photoelectric switch also includes a housing, the said housing fixedly mounted on the said base, the said housing has two pairs of tube holders, the said two pairs of tube holders have an on-off slot between them, the said transmitting tube and the said receiving tube are respectively mounted in the said two pairs of transmitting holders, and the transmitting port of the said transmitting tube and the receiving port of the said receiving tube face the said on-off slot and directly face each other.

3. A modular photoelectric-switch keyboard key according to Claim 2, wherein the said two pairs of tube holders has a through slot on the side near the said on-off slot, and the said transmitting port and the said receiving port directly face the said through slot.

4. A modular photoelectric-switch keyboard key according to Claim 2, wherein an engagement portion is provided on the side of the said transmitting tube and the said receiving tube, and a mating portion for connecting with the said engagement portion is provided on the side wall for the said two tube holders to correspond with the said engagement portion.

5. A modular photoelectric-switch keyboard key according to Claim 2, wherein a lock piece is provided at the bottom of the housing, and the said lock piece is locked with the circuit board.

6. A modular photoelectric-switch keyboard key according to Claim 1, wherein the said modular photoelectric-switch keyboard key also includes an elastic strip, the said elastic strip is fixed on the said base, the said elastic strip has elastic tongue piece, the said keymodule is provided with a retainer portion, and the said elastic tongue piece provides an elastic force perpendicular to the sliding direction of the said keymodule and retains against the said retainer portion.

7. A modular photoelectric-switch keyboard key according to Claim 6, wherein the said keymodule comprises plunger and slider that is slideably connected outside the said plunger; the said plunger is provided with a suspension portion, and when the key is not pressed, the said slider is suspended on the said suspension portion, and the said retaining portion presses against the said elastic tongue piece.

8. A modular photoelectric-switch keyboard key according to Claim 1, wherein locating pole is provided on the underside of the said base, and the said locating pole is inserted into the locating hole of the circuit board.

9. A modular photoelectric-switch keyboard key according to Claim 1, wherein the said base has an elastic hook provided on one side of the base, a fixing plate is provided above the said circuit board, the said base is mounted on the opening of the said fixing plate and the said elastic hook is clamped on the rim of the said opening.

10. A modular photoelectric-switch keyboard key according to Claim 1, wherein the said base comprises a top cover and housing, either the said top cover or the said housing is provided with a engagement hook, the other one of the said top cover or the said housing has an engagement portion, and when the said top cover is covered on the said housing, the said engagement hook is engaged with the said engagement portion.
